# EUROPÄISCHE PATENTSCHRIFT

(11) **EP 2 564 442 B1**
(45) Veröffentlichungstag und Bekanntmachung des Hinweises auf die Patenterteilung: **22.08.2018**
(21) Anmeldenummer: 11716563.9
(22) Anmeldetag: 28.04.2011
(51) Int. Cl.: H01L 51/52

(54) **FLÄCHIGER LEUCHTKÖRPER MIT HOMOGENER LEUCHTDICHTE UND VERFAHREN ZUM ERHÖHEN DER HOMOGENITÄT DER LEUCHTDICHTE EINES FLÄCHIGEN LEUCHTKÖRPERS**
PLANAR LUMINOUS ELEMENT HAVING HOMOGENEOUS LIGHT DISTRIBUTION AND METHOD FOR INCREASING THE HOMOGENEITY OF THE LIGHT DISTRIBUTION OF A PLANAR LUMINOUS ELEMENT
ÉLÉMENT LUMINEUX PLAT À LUMINANCE HOMOGÈNE ET PROCÉDÉ POUR ACCROÎTRE L'HOMOGÉNÉITÉ DE LA LUMINANCE D'UN ÉLÉMENT LUMINEUX PLAT

(30) Priorität: 09.06.2010 DE 102010029848; 30.04.2010 DE 102010028456
(43) Veröffentlichungstag der Anmeldung: 06.03.2013
(73) Patentinhaber: Tridonic GmbH & Co KG, 6851 Dornbirn (AT)
(72) Erfinder: KIRCHHOF, Christian, 01099 Dresden (DE); AMELDUNG, Jörg, 01099 Dresden (DE)
(74) Vertreter: Thun, Clemens
(86) Internationale Anmeldenummer: PCT/EP2011/056777
(87) Internationale Veröffentlichungsnummer: WO 2011/135045

(56) Entgegenhaltungen:
- WO-A1-2004/070837
- WO-A1-2007/004470
- JP-A- 5 315 073
- JP-A- 11 312 582
- JP-A- 2009 054 426

## Beschreibung

Die vorliegende Erfindung bezieht sich auf einen flächigen Leuchtkörper mit homogener Leuchtdichte und ein Verfahren zum Erhöhen der Homogenität der Leuchtdichteverteilung über der Abstrahlfläche eines flächigen Leuchtkörpers, wie bspw. eines OLED-Panels oder OLED-Moduls.

Auf der Basis organischer Leuchtdioden (OLED = Organic Light Emitting Diode) können neuartige Leuchtelemente verwirklicht werden. Als flächige Leuchtkörper, die gegenüber anorganischen LEDs (LED = Light Emitting Diode) eine moderate Leuchtdichte aufweisen, sind OLEDs bestens geeignet für die Herstellung flächiger diffuser Lichtquellen, wie beispielsweise Leuchtpanels. Großflächige, diffus abstrahlende Lichtquellen sind insbesondere für Anwendungen in der allgemeinen Beleuchtung erwünscht, womit OLEDs ein vielversprechendes Zukunftspotenzial für diesen Anwendungsgebiete haben. In Folge der verwendeten Dünnschichttechnologie bei der Herstellung von OLEDs kann es ferner möglich werden, flexible Leuchtkörper zu realisieren, die bisher nicht bekannte Möglichkeiten zur Beleuchtung von Räumen eröffnen.

Für praktische Anwendungen, insbesondere in der allgemeinen Beleuchtung, sind gleichmäßig leuchtende OLEDs, d.h. OLEDs, die über ihre Abstrahlfläche gleichmäßig Licht abgeben, erwünscht bzw. gefordert. Analog zu anorganischen LEDs sind organische LEDs strombetriebene Bauelemente. Dies bedeutet, dass die Leuchtdichte der OLED mit dem durch die lichtemittierende, aktive Schicht der OLED fließenden Strom korreliert ist. Zur Realisierung gleichmäßig leuchtender OLEDs ist daher innerhalb der lichtemittierenden Schicht eine über die flächige Ausdehnung der OLED homogene Stromdichte erforderlich. Bei der Herstellung großflächiger Leuchtelemente stellt dies aber insbesondere eine Herausforderung dar. Typischerweise weist eine OLED mindestens eine transparente Elektrode auf, die beispielsweise mittels eines transparenten leitfähigen Oxids (TCO = Transparent Conductive Oxide) oder mittels durchsichtiger Metallschichten realisiert wird. Da die elektrische Leitfähigkeit dieser transparenten Elektrodenmaterialien allerdings gering ist, ist der Spannungsabfall innerhalb einer Elektrode nicht zu vernachlässigen. Aufgrund der Strom-Spannungscharakteristik einer OLED wirken sich geringe Spannungsunterschiede innerhalb einer Elektrodenfläche als wahrzunehmende, unerwünschte Helligkeitsunterschiede aus. Bei geforderter Homogenität der Leuchtdichte ist dadurch die maximal erreichbare Leuchtflächengröße beschränkt.

Aufgrund der geringen elektrischen Leitfähigkeit der transparenten Elektrode ist es häufig erforderlich, größere Leuchtflächen in Segmente oder Einzelflächen zu unterteilen. Für eine größere Leuchtfläche sind somit mehrere Einzelleuchtelemente zusammenzuschließen, wobei dann ein elektrisches Kontaktierungssystem erforderlich ist, um eine effiziente Ansteuerung großflächiger OLED-Leuchtflächen zu ermöglichen. Dieses Kontaktierungssystem sollte so ausgelegt sein, dass ein Maximum an homogener Leuchtfläche erreicht werden kann.

Der Standardaufbau einer konventionellen OLED kann wie folgt zusammengefasst werden. Im Wesentlichen besteht eine OLED bzw. ein OLED-Panel aus zwei flächig ausgebildeten Elektroden (von denen zumindest eine transparent ist), zwischen denen mindestens eine Schicht aus organischen Materialien eingebettet ist. Bei Anlegen einer geeigneten Spannung bzw. Einprägen eines geeigneten Stroms kann in der aktiven organischen Schicht elektromagnetische Strahlung, vorzugsweise Licht, emittiert werden. Das OLED-Panel kann als so genanntes bottom- oder top-emittierendes Bauelement ausgeführt sein. Auch eine transparente Ausgestaltung der OLED ist möglich.

In einem konkreten Beispiel kann als transparente Elektrode Indium-Zinn-Oxid (ITO = Indium Tin Oxide) mit einer Schichtdicke von ca. 100 nm verwendet werden, wobei häufig die ITO-Schicht auf ein Glassubstrat aufgebracht wird und als Anode dienen kann. Darauf folgt eine organische Schicht oder eine organische Schichtstruktur, die teilweise bis zu 7 Sublagen oder Schichten aufweisen kann, mit einer Schichtdicke von ca. 100 bis 200 nm. Abschließend wird eine metallische Kathode, die beispielsweise Aluminium aufweisen kann, mit einer Schichtdicke von ca. 100 bis 500 nm Dicke aufgebracht. Mit zunehmender Größe des OLED-Panels wird es nun schwieriger, eine homogene Lichtabstrahlung zu erzielen. Der verhältnismäßig hochohmige Widerstand der ITO-Schicht führt bei großflächigen Leuchtelementen häufig zu einer Inhomogenität der Leuchtdichteverteilung. So kann der hochohmige Widerstand der ITO-Schicht beispielsweise einen Wert von ca. 10 bis 20 Ohm/square (square = Quadratfläche) betragen. Eine Ursache für die Inhomogenität liegt beispielsweise darin, dass die Kontaktierung der ITO-Schicht für die Stromzufuhr oft nur in den Randbereichen des Leuchtelements möglich ist. Bei einer Helligkeit von 1000 cd/m2 und einer Stromeffizienz von 50 cd/A benötigt eine übliche OLED mit einer Grundfläche von 50 mm x 50 mm im Betrieb einen Stromfluss in der Größenordnung von etwa 0,05 A. Werden nun die Elektroden der OLED nur von einer Seite kontaktiert, so kann dies zu einem Spannungsabfall in der Größenordnung von bis zu 0,5 V führen. Für übliche OLEDs bewirkt diese Spannungsdifferenz zwischen dem Bereich des Anschlusses an die Elektrode und von dem Anschluss entfernten Abschnitten der Elektrode bereits einen Helligkeitsunterschied, welcher mit bloßem Auge wahrnehmbar ist. Im Arbeitspunkt einer OLED ist die Strom-Spannungscharakteristik (I-V-Kurve) einer OLED typischerweise besonders steil, daher wirken sich geringe Spannungsunterschiede innerhalb einer Elektrodenfläche auf die Leuchtdichteverteilung aus. Für OLED-Panels, die sich durch eine besonders steile I-V-Kurve auszeichnen, kann ein solcher Spannungsunterschied beispielsweise bereits einen Faktor von mehr als 100 in der Helligkeit des Bauelementes ausmachen.

Um den Flächenwiderstand der transparenten Elektrode zu reduzieren und damit größere Abmessungen des OLED-Panels erreichen zu können, ist bekannt, Metallverstärkungen in Form von Netzen in die ITO-Schicht einzubringen. Diese Metallgrids (Metallgitter oder sogenannte Busbars) verringern den effektiven Schichtwiderstand entsprechend deren Belegungsdichte und ermöglichen somit eine Realisierung größerer Diodenflächen. Die Herstellung eines solchen Metallgitters ist jedoch technisch aufwendig und erfordert mehrere zusätzliche Lithografieschritte im Herstellungsprozess. Aufgrund der Nichttransparenz dieser Metallgrids verringert sich zudem die effektive Leuchtfläche entsprechend. Aus diesem Grund sind Metallgrids beispielsweise nur bis zu 25% der ITO-Fläche überhaupt sinnvoll. Eine mögliche Verbesserung wäre beispielsweise eine Erhöhung der Gridmetalldicke, was aber aufgrund von Strukturierungsmöglichkeiten und der Schichtdicken der organischen Schichten nicht sinnvoll ist. Eine metallverstärkte ITO-Schicht wird außerdem nur an den Außenkanten kontaktiert, wodurch trotz der effektiven Widerstandsverringerung die maximale Größe des Leuchtelements limitiert bleibt.

Aus der WO09135466 ist es bekannt, den Spannungsabfall über die Elektrodenfläche durch einen gegenläufigen Widerstandsgradienten innerhalb der organischen Schicht(en) zu kompensieren. Dieser Widerstandsgradient kann beispielsweise durch Bestrahlung erzielt werden, dies ist jedoch prozesstechnisch aufwendig zu realisieren. Fertigungstoleranzen, die aufgrund von Prozessschwankungen in späteren Herstellungsschritten auftreten, können hierbei nicht ausgeglichen werden.

Neben einem geringen effektiven Flächenwiderstand der transparenten Elektrode ist für eine gleichmäßig strahlende OLED eine gleichmäßige Stromeinspeisung notwendig. Um nun die Homogenität der Leuchtdichteverteilung des abgestrahlten Lichts über die flächige Ausdehnung der OLED zu verbessern, sind am OLED Panel häufig mehrere Einspeisepunkte für den Betriebsstrom vorgesehen, d.h. es befinden sich an einer bzw. beiden Elektroden mehrere Stellen, über die die Elektroden kontaktiert werden. Typischerweise wird dabei eine möglichst symmetrische Kontaktierung des OLED-Panels angestrebt. Meist weist die Anode mehrere Kontaktierungsstellen auf, da diese im allgemeinen eine geringere Leitfähigkeit aufweist. Es kann aber auch vorgesehen sein, dass die Kathode oder beide Elektroden, Anode und Kathode, mehrere Kontaktierungsstellen aufweisen, über die der Betriebsstrom zu bzw. abfließt. Aus der DE 102006016373 A1 ist ein alternativer Ansatz zur Verbesserung der Homogenität der Leuchtdichteverteilung bekannt, bei dem ein Kontaktierungsbereich als ein umlaufender Rahmen ausgebildet ist, um eine gleichmäßige Einspeisung des Betriebsstroms in den aktiven OLED-Bereich zu erreichen.

Aufgrund ihres komplexen Aufbaus sind OLEDs bei der Fertigung gewissen Prozessschwankungen und Fertigungstoleranzen unterworfen. So können aufgrund von Prozessschwankungen bei der Fertigung Inhomogenitäten des Widerstands innerhalb der Elektrodenfläche, oder auch innerhalb der organischen, lichtemittierenden Schicht(en) auftreten. Ebenso kann es zu Ungleichmäßigkeiten bei der Kontaktierung kommen, welche nicht von vornherein berücksichtigt und im Herstellungsprozess kompensiert werden können. Aufgrund der Strom-Spannungscharakteristik von OLEDs können sich selbst kleine Fertigungstoleranzen nachteilig für die Homogenität der Leuchtdichte auswirken.

Aus der WO 2007/004470 A1 ist eine Lichtabgabevorrichtung mit einem organischen Leuchtelement bekannt. Die Lichtabgabevorrichtung weist zwei Elektroden auf, wobei die zweite Elektrode mehrere streifenförmige Elektrodenunterbereiche umfasst. Zwischen die Elektrodenunterbereiche und einer äußeren Stromverdrahtung sind Anschlussbereiche geschaltet, deren Längen so einstellbar sind, dass eine gleichförmige Lichtabgabe erzielt wird.

Aus der JP 11-312582 A ist ein organisches Lichtabgabeelement mit einem Widerstandselement bekannt, das durch ein Lasertrimmen eingestellt werden kann.

Aus der JP 05-315073 A ist ein flächiger organischer Leuchtkörper bekannt, bei dem die zweite Elektrodenschicht rechteckförmig ist und an jeder Seite fünf Kontaktbereiche aufweist. Durch einen vorgeschalteten Widerstand kann der Strom so eingestellt werden, dass eine möglichst homogene Lichtabgabe bewirkt wird. Eine Veränderung des Widerstands kann durch eine Laserbehandlung bewirkt werden.

Aus der WO 2004/070837 A1 ist eine Trägeranordnung für eine organische Leuchtdiode bekannt. Die Trägeranordnung weist eine Isoliersubstratschicht auf, auf deren Vorderseite Anschlüsse für die organische Leuchtdiode angeordnet sind und auf deren Rückseite rückseitige Kontaktstellen angeordnet sind. Dabei sind die Anschlüsse auf der Vorderseite mit den rückseitigen Anschlüssen über Durchkontaktierungen elektrisch verbunden.

Aus der JP 2009-054426 A ist ein flächiger Leuchtkörper bekannt, dessen Stromzufuhr mittels einem, durch Lasertrimmen veränderbaren Widerstand beeinflusst werden kann.

Aufgabe der vorliegenden Erfindung ist es daher, einen flächigen Leuchtkörper bereitzustellen, der sich durch eine möglichst homogene Leuchtdichte auszeichnet sowie ein Verfahren zum Erhöhen der Homogenität der Leuchtdichte eines flächigen Leuchtkörpers zu schaffen. Die Verbesserung der Homogenität der Leuchtdichte sollte dabei auf einfache Art und Weise und möglichst kostengünstig realisierbar sein.

Diese Aufgabe wird durch einen flächigen Leuchtkörper gemäß Anspruch 1 und ein Verfahren gemäß Anspruch 5 gelöst. Vorteilhafte Weiterbildungen sind Gegenstand der abhängigen Ansprüche.

Erfindungsgemäß wird ein flächiger Leuchtkörper, insbesondere ein OLED-Panel, vorgeschlagen, welcher eine Schichtanordnung mit einer ersten und einer zweiten Elektrodenschicht und zumindest einer dazwischen liegenden lichtemittierenden Schicht aufweist, wobei eine Mehrzahl von Kontaktbereichen zur Kontaktierung der ersten Elektrodenschicht und zumindest ein Kontaktbereich zur Kontaktierung der zweiten Elektrodenschicht vorgesehen sind. Ferner ist zumindest zu einem Kontaktbereich der zur Kontaktierung vorgesehenen Kontaktbereiche ein abgleichbares Widerstandselement elektrisch in Serie geschaltet, wobei der Widerstandswert des abgleichbaren Widerstandselements einstellbar ist. Wird daher der flächige Leuchtkörper über diesen Kontaktbereich kontaktiert, so wird der Stromfluss über diesen Kontaktbereich durch den Widerstandswert des Widerstandselements mitbestimmt. Der Widerstandswert kann bevorzugt auf einen geänderten Widerstandswert einstellbar sein, bei dem die Schichtanordnung gegenüber einem Zustand ohne geänderten Widerstandswert eine homogenere Leuchtdichte aufweist.

Optional bzw. alternativ zur oben erwähnten erfindungsgemäßen Anordnung des abgleichbaren Widerstandselements kann in einer bevorzugten Ausführungsform ein abgleichbares Widerstandselement zwischen einen zur Kontaktierung der ersten Elektrodenschicht vorgesehenen Kontaktbereich und einen zur Kontaktierung der zweiten Elektrodenschicht vorgesehenen Kontaktbereich geschaltet sein. Dieses Widerstandselement, welches vergleichsweise hochohmig ist, ist somit elektrisch parallel zur lichtemittierenden Schicht des flächigen Leuchtkörpers angeordnet.

Mittels des abgleichbaren Widerstandselements können nun Unterschiede bei den Anschlusswiderständen, hervorgerufen durch unterschiedliche Übergangs- und/oder Kontaktwiderstände an den einzelnen Kontaktierungsbereichen, ausgeglichen werden. Zu einem geringeren Maß können auch, primär durch die Parallelanordnung des abgleichbaren Widerstandselements, Inhomogenitäten des Widerstands innerhalb der lichtemittierenden Schicht(en) oder innerhalb der Elektrodenfläche ausgeglichen werden. Durch die Parallelanordnung des abgleichbaren Widerstandselements wird es zudem möglich, die Strom-Spannungskennlinie des flächigen Leuchtkörpers geringfügig zu modifizieren.

Erfindungsgemäß kann durch einen entsprechenden Abgleichvorgang an dem zumindest einen abgleichbaren Widerstandselement eine über die Abstrahlfläche homogene oder zumindest eine gegenüber einem unveränderten Ausgangszustand ohne einem durchgeführten Widerstandsabgleich homogenere Leuchtdichte erreicht werden.

Der Widerstandswert des abgleichbaren Widerstandselements kann beispielsweise mittels eines Lastertrimmvorgangs oder eines Laserablationsvorgangs einstellbar sein.

Erfindungsgemäß wird ein flächiger Leuchtkörper, insbesondere ein OLED-Modul, vorgeschlagenen, wobei die Schichtanordnung, welche die Elektroden und lichtemittierende Schicht umfasst, mit einem Basiselement, bspw. einer Platine, verbunden ist. Das Basiselement weist Zwischenkontaktbereiche an einer der ersten, der Schichtanordnung zugewandten Hauptoberfläche, die mit den Kontaktbereichen der Schichtanordnung verbunden sind, und Außenkontakte an einer zweiten Hauptoberfläche, die mit den zugehörigen Zwischenkontaktbereichen auf der ersten Hauptoberfläche der Platine elektrisch verbunden sind, auf. Erfindungsgemäß ist das abgleichbare Widerstandselement seriell zwischen den Zwischenkontaktbereich auf der ersten Hauptoberfläche des Basiselements, der mit dem zumindest einen zur Kontaktierung vorgesehenen Kontaktbereich der Schichtanordnung elektrisch verbunden ist, und den zugeordneten Außenbereich geschaltet. Erfindungsgemäß weist das abgleichbare Widerstandselement eine trimmbare Dickschichtwiderstandsstruktur, eine trimmbare Dünnschichtwiderstandsstruktur, ein trimmbares SMD-Widerstandselement oder eine trimmbare integrierte Widerstandsstruktur auf oder ein einstellbares Potentiometer oder eine programmierbare elektronische Lastschaltung.

In einer vorteilhaften Ausführungsform kann die Schichtanordnung des flächigen Leuchtkörpers eine Mehrzahl von Kontaktbereichen zur Kontaktierung der zweiten Elektrodenschicht aufweisen.

Ferner kann vorgesehen sein, dass jeder der zur Kontaktierung vorgesehenen Kontaktbereiche ein abgleichbares Widerstandselement aufweist.

Bevorzugt ist der erfindungsgemäße flächige Leuchtkörper aus organische Leuchtdioden aufgebaut, jedoch ist die Erfindung nicht darauf beschränkt. Die Erfindung kann für beliebige flächige Leuchtkörper, bei denen sich eine lichtemittierende Schicht zwischen zwei flächigen Elektroden befindet, wie beispielsweise bei einer lichtemittierenden elektrochemischen Zelle (LEC), angewandt werden.

Im Kontext von organischen Leuchtdioden ist der Erfindungsgedanke sowohl für die Kontaktierung eines OLED-Panels als auch eines OLED-Moduls anwendbar. Im Rahmen der vorliegenden Erfindung wird unter einem OLED-Panel eine Schichtanordnung verstanden, bei der auf einem Substrat (beispielsweise Glas) die einzelnen Schichten (die beiden Elektroden mit der dazwischenliegenden lichtemittierenden Schichtstruktur) aufgebracht sind. Die gesamte Anordnung kann ferner zum Schutz gegen die Umgebungsatmosphäre, d.h. gegen Sauerstoff und Luftfeuchtigkeit, noch mit einer Verkapselung versehen sein. Das OLED Panel kann als bottom- oder top-emittierendes Bauteil ausgeführt sein. Unter einem OLED Modul ist eine Anordnung zu verstehen, bei der ein OLED-Panel mit einer Platine verbunden ist. Die Platine kann dabei definierte elektrische Schnittstellen (Außenkontakte) aufweisen, über die das OLED-Panel mit Betriebsstrom versorgt wird. Das OLED-Modul kann an einer Trägerplatte einer Leuchte befestigbar sein oder in eine Fassung lösbar einsetzbar sein, d.h. in einfacher Art und Weise ohne individuelle Anpassung in eine Leuchte eingebaut werden. Die Platine hat nun unter anderem die Funktion, den Strom von einer oder mehreren definierten Schnittstellen, die nach Möglichkeit standardisiert ausgeführt sind, auf die jeweiligen, an die individuelle Form des OLED-Panels optimierten Kontaktbereiche zu verteilen. Optional kann noch zusätzliche Elektronik mit Zusatzfunktionen auf der Platine vorgesehen sein.

Die Erfindung umfasst weiters ein Verfahren zum Erhöhen der Homogenität der Leuchtdichte eines flächigen Leuchtkörpers. Um Inhomogenitäten der Leuchtdichte des flächigen Leuchtkörpers zu reduzieren, wird erfindungsgemäß ein Abgleich eines oder mehrerer Widerstandselemente an den zur Kontaktierung des flächigen Leuchtkörpers vorgesehenen Kontaktbereichen vorgenommen. Damit kann eine gleichmäßigere Kontaktierung des Leuchtkörpers und damit eine homogenere Leuchtdichteverteilung über der Fläche des Leuchtkörpers gegenüber einem (inhomogenen) Ausgangszustand ohne einem durchgeführten Abgleich an einem oder mehreren Widerstandselementen erhalten werden.

Um nun die erforderlichen Widerstandswerte an den abgleichbaren Widerstandselementen für die erwünschte homogene Leuchtdichteverteilung des Leuchtkörpers zu ermitteln, werden geeignete Parameter oder Kenngrößen benötigt, die Rückschlüsse auf Leuchtdichteinhomogenitäten erlauben. Erfindungsgemäß kann eine Homogenitätsmessung der Leuchtdichte des Leuchtkörpers durchgeführt werden, bei der als beispielhafte Messparameter eine Position, Ausdehnung und/oder Leuchtdichte einer oder mehrerer Inhomogenitäten in der Leuchtdichteverteilung über der Abstrahlfläche des Leuchtkörpers erfasst werden. Alternativ können Unterschiede in den Kontakt- oder Übergangswiderständen oder Asymmetrien der Elektrodenschichtwiderstände messtechnisch dadurch ermittelt werden, dass ein Messstroms abwechselnd zwischen jeweils unterschiedlichen Kontaktierungspaaren eingeprägt wird, wobei ein Kontaktierungspaar durch zwei verschiedene Kontaktierungsbereiche gebildet wird. Über Leitfähigkeitsmessungen können dann mögliche Asymmetrien an den zur Kontaktierung des Leuchtkörpers vorgesehenen Kontaktierungsbereichen ermittelt werden.

Basierend auf derartig erfassten Parametern kann nun auf eine asymmetrische Einspeisung des Betriebsstroms oder eine Inhomogenität der Betriebsstromverteilung in dem aktiven Bereich des Leuchtkörpers und damit auf den jeweils erforderlichen Widerstandswert bzw. die erforderliche Änderung des Widerstandswerts an dem abgleichbaren Widerstandselement geschlossen werden. Basierend auf dem ermittelten Widerstandswert für den zumindest einen Kontaktbereich wird dann der Abgleich des Widerstandswerts an dem abgleichbaren Widerstandselement durchgeführt. Erfindungsgemäß kann gleichermaßen der jeweils erforderliche Widerstandswert für mehrere oder alle Kontaktbereiche (d.h. für die aufgeteilte Anode und/oder Kathode) ermittelt werden und dann der Abgleich der Widerstandswerte an diesen abgleichbaren Widerstandselementen durchgeführt werden.

Der Widerstandsabgleich kann bspw. mittels eines Lasertrimmvorgangs oder eines Laserablationsvorgangs durchgeführt wird.

Ferner ist zum Einstellen des ermittelten Widerstandswerts auch das Einsetzen eines jeweils geeigneten Serienwiderstandselements an zumindest einem der zur Kontaktierung vorgesehenen Kontaktbereiche des flächigen Leuchtkörpers möglich, wobei der Widerstandswert des einzusetzenden Widerstandselements den für eine homogenere Leuchtdichteverteilung vorgesehenen Widerstandswert aufweist. Auch hier können für einen, mehrere oder alle Kontaktbereiche das jeweils geeignete Serienwiderstandselement bestimmt und eingestellt werden.

Die erfindungsgemäße Ermittlung des für eine (möglichst) homogene Leuchtdichteverteilung des Leuchtkörpers erforderlichen Widerstandswerts kann jeweils für einen, mehrere oder alle Kontaktbereiche des Leuchtkörpers durchgeführt werden. Entsprechend kann die Einstellung auf den gewünschten Widerstandswerte an einem, mehreren oder allen Kontaktbereichen durchgeführt werden. So kann für jeden Kontaktbereich mit einem abgleichbaren Widerstandselement ein Widerstandswert für eine homogene Leuchtdichteverteilung des Leuchtkörpers bestimmt werden, und der jeweilige bestimmte Widerstandswert eingestellt werden.

Bevorzugt kann der Abgleich der abgleichbaren Widerstandselemente individuell an den verschiedenen Kontaktbereichen derart erfolgen, so dass nach Abgleich an den Kontaktbereichen im Wesentlichen der gleiche Widerstandswert zum Leuchtkörper vorliegt, welche eine homogenere Leuchtdichteverteilung des Leuchtkörpers ermöglicht. Alternativ können die abgleichbaren Widerstandselemente gleichmäßig auf jeweils erhöhte Widerstandswerte erhöht werden, so dass sich aufgrund des erhöhten Vorwiderstands mögliche störende, unterschiedliche Kontakt- und Übergangswiderstände an den Kontaktbereichen nicht oder deutlich weniger auf die Leuchtdichteverteilung auswirken.

Im Rahmen der vorliegenden Erfindung sollte ferner beachtet werden, dass die Bezugnahme auf den Widerstandswert bzw. die Widerstandswerte, die für eine homogene Leuchtdichteverteilung des Leuchtkörpers erforderlich sind, nicht unbedingt auf die absolut exakten Widerstandswerte für eine absolut exakte homogene Leuchtdichteverteilung bzw. symmetrische Kontaktierung bezogen sind, sondern beispielsweise innerhalb eines Toleranzbereiches von 50%, 20%, 10% oder 1% die erforderlichen Widerstandswerte angeben, die zu einer Erhöhung (oder zum Erreichen) der Homogenität der Leuchtdichteverteilung über der Abstrahlfläche eines flächigen Lichtkörpers beitragen.

Somit wird erfindungsgemäß zunächst an zumindest einem der Mehrzahl zur Kontaktierung vorgesehenen Kontaktbereiche des Leuchtkörpers ein Widerstandswert ermittelt, der (innerhalb eines Toleranzbereichs) für eine homogene Leuchtdichteverteilung des Leuchtkörpers erforderlich ist.

Basierend auf diesem ermittelten Widerstandswert wird nun der Widerstandswert an diesem Kontaktbereich (innerhalb eines Toleranzbereichs) auf den für eine homogenere Leuchtdichteverteilung des Leuchtkörpers erforderlichen Widerstandswert eingestellt.

Ziel der Erfindung ist es somit, eine möglichst hohe Homogenität der Leuchtdichte über die Abstrahlfläche des flächigen Leuchtkörpers zu erzielen.

Nachfolgend soll die Erfindung anhand der beiliegenden Zeichnungen näher erläutert werden. Es zeigt:
- Fig. 1 a-b: eine schematische Draufsicht auf ein OLED-Panel und eine Detailansicht von Kontaktbereichen des OLED-Panels das kein Teil der beanspruchten Erfindung darstellt;

- Fig. 2a-b: eine schematische Draufsicht auf ein OLED-Panel und eine Detailansicht von Kontaktbereichen des OLED-Panels das kein Teil der beanspruchten Erfindung darstellt;

- Fig. 3: eine schematische Draufsicht auf ein OLED-Panel mit Kontaktbereichen das kein Teil der beanspruchten Erfindung darstellt;

- Fig. 4a-b: eine schematische Seitenansicht auf ein OLED-Modul und eine schematische Draufsicht auf einen Teil des OLED-Moduls gemäß einem Ausführungsbeispiel der vorliegenden Erfindung.

Bevor nachfolgend die vorliegende Erfindung im Detail anhand der Zeichnungen näher erläutert wird, wird darauf hingewiesen, dass funktionsgleiche oder gleichwirkende Elemente in den Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

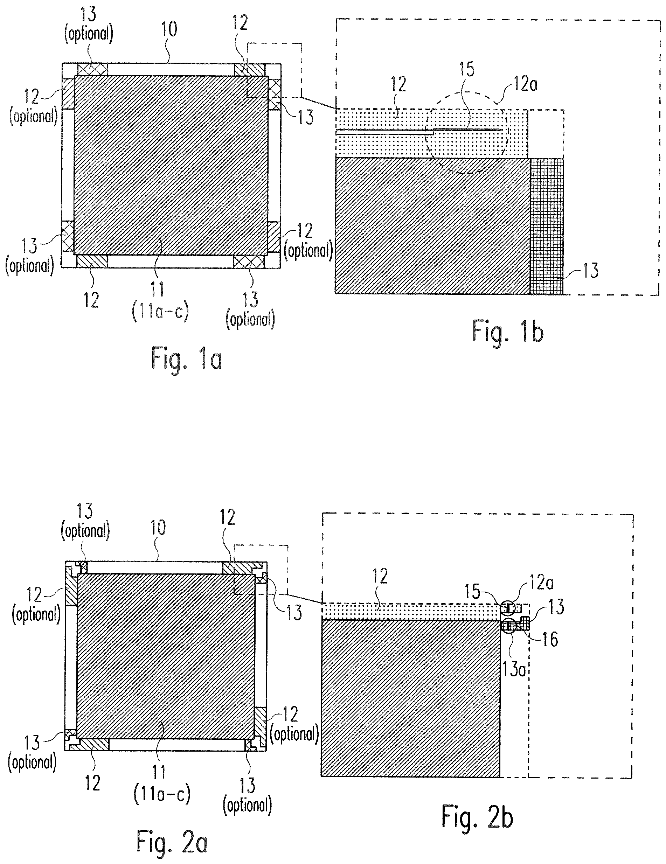

Fig. 1a zeigt nun eine Draufsicht auf ein OLED-Panel 10. Ein Beispiel für ein OLED-Panel wurde in der Einleitung erwähnt. Das OLED-Panel 10, das bspw. in Form einer OLED-Platte oder OLED-Folie vorliegen kann, weist einen Schichtstapel 11 auf, der auf ein Substrat aufgebracht ist. Das OLED-Panel kann starr (als OLED-Platte) ausgebildet sein, wenn beispielsweise eine Glasplatte als Substrat verwendet wird. Das OLED-Panel kann auch flexibel (als OLED-Folie) ausgebildet sein, wenn bspw. eine Folie als Substrat verwendet wird. Als Substratmaterialien sind beispielsweise auch Metallfolien denkbar, bei denen eine isolierende Schicht aufgebracht wird, bevor der aktive Schichtstapel 11 gebildet wird. Der aktive Schichtstapel 11 weist eine erste Elektrodenschicht 11a (z.B. einer Anodenschicht), eine zweite Elektrodenschicht 11c (z.B. einer Kathodenschicht) und zumindest eine organischen Licht-emittierende Zwischenschicht 11b, die zwischen der ersten Elektrodenschicht 11a und der zweiten Elektrodenschicht 11c angeordnet ist, auf. Ferner sind Kontaktbereiche 12, 13 an der Oberfläche des OLED-Panels 10 zur Kontaktierung des aktiven Schichtstapels 11 angeordnet.

In den Figuren 1a-b weist das OLED-Panel 10 eine quadratische Grundform auf, die aber als rein beispielhaft anzunehmen ist. Es sind OLED-Panels mit beliebiger Geometrie als Grundform denkbar, wobei sich auch die Grundform (die Form des Substrats) von der Form des aktiven Schichtstapels 11, d.h. dem aktiv leuchtenden Feld, unterscheiden kann.

Bei dem in Fig. 1a-b dargestellten Beispiel weist das OLED-Panel 10 beispielsweise eine Mehrzahl von Kontaktbereichen 12 zur Kontaktierung der ersten Elektrodenschicht 11a und zumindest einen Kontaktbereich 13 zur Kontaktierung der zweiten Elektrodenschicht 11b auf. Die Kontaktbereiche 12 bilden beispielsweise die Anodenkontaktbereiche, die die Anodenschicht zur Einspeisung eines Betriebsstroms kontaktieren, während die Kontaktbereiche 13 beispielsweise als Kathodenkontaktbereiche, die die Kathodenschicht zum Auskoppeln des Betriebsstroms kontaktieren, ausgebildet sind. Alternativ kann auch die erste Elektrodenschicht 11a als Kathodenschicht und die zweite Elektrodenschicht 11c als Anodenschicht ausgebildet sein, so dass dann der Kontaktbereich 12 als Kathodenkontaktbereich und der Kontaktbereich 13 als Anodenkontaktbereich ausgebildet ist.

Im hier dargestellten Beispiel weist die Schichtanordnung 10 zwei Kontaktbereiche 12 (z.B. Anodenkontaktbereiche) zur Kontaktierung der ersten Elektrodenschicht 11a und einen Kontaktbereich 13 zur Kontaktierung der zweiten Elektrodenschicht 11c (z.B. einen Kathodenkontaktbereich) auf. Alternativ könnte die Schichtanordnung 10 auch zwei als Kathodenkontaktbereiche ausgebildete Kontaktbereiche 12 und einen als Anodenkontaktbereich ausgebildeten Kontaktbereich 13 aufweisen. In einer bevorzugten Ausführungsform sind die Kontaktbereiche 12, 13 im Bereich der Ecken angeordnet.

Die genaue Anzahl, Positionierung und Form der Kontaktbereiche 12, 13 sind für die Erfindung von untergeordneter Bedeutung. Bevorzugt sind die Kontaktbereiche 12, 13 so angeordnet, dass eine möglichst gleichmäßige Stromverteilung in das OLED-Panel und eine damit verbundene gleichmäßige Stromverteilung innerhalb der aktiven Schicht 11 des OLED-Panels 10 möglich wird. Es wird darauf hingewiesen, dass neben den im Fig. 1a dargestellten Kontaktbereichen 12, 13 zusätzliche oder anders positionierte Kontaktbereiche 12, 13 vorgesehen sein können. Eine bevorzugte Variante weist Kontaktbereiche 12, 13 im Bereich von allen vier Ecken auf (die zusätzlichen Kontaktbereiche sind in der Fig. 1a mit optional gekennzeichnet). Die jeweiligen Kontaktbereiche 12, 13 können als längliche Streifen oder in einer anderen geometrischen Form entlang des Randbereichs des OLED-Panels 10 ausgebildet sein. So können die Kontaktbereiche 12, 13 jeweils paarweise an mehreren oder allen Rand- oder Eckbereichen des OLED-Panels angeordnet sein.

Aufgrund von Fertigungstoleranzen oder Prozessschwankungen können nun nicht vorhersagbare Kontakt- und Übergangswiderstände zwischen den jeweiligen Kontaktbereichen 12, 13 und den Elektroden des Schichtstapels 11 auftreten, wobei bereits kleine Asymmetrien in den Anschlusswiderständen oder Elektrodenwiderständen zu einer Leuchtdichteinhomogenität an dem OLED-Panel 10 führen können. Erfindungsgemäß sind daher im Bereich der Kontaktbereiche 12,13 abgleichbare Widerstandselemente 12a vorgesehen, über die bei Kontaktierung der Strom fließt.

Um bei Auftreten einer Inhomogenität der Leuchtdichte des OLED-Panels 10 aufgrund einer ungleichmäßigen Kontaktierung des OLED-Panels 10 entgegenzuwirken, wird nun zunächst an zumindest einem der Mehrzahl zur Kontaktierung vorgesehenen Kontaktbereiche 12, 13 des OLED-Panels 10 der für eine homogenere Leuchtdichteverteilung des OLED-Panels 10 erforderliche Widerstandswert ermittelt, bei dem sich gegenüber einem unveränderten Widerstandswert eine homogenere Leuchtdichteverteilung der Schichtanordnung 10 ergibt. Dazu wird beispielsweise die von dem OLED-Panel 10 erreichte Homogenität der Leuchtdichteverteilung bei einer Betriebsstromeinspeisung ausgewertet, wobei beispielsweise als Messparameter eine Position, Ausdehnung und/oder Leuchtdichte einer Inhomogenität in der Leuchtdichteverteilung bezogen auf die Abstrahlfläche des flächigen Leuchtkörpers 10 erfasst wird. Basierend auf diesem erfassten Parameter in Form von Position, Ausdehnung und/oder Leuchtdichte einer Inhomogenität kann nun der für eine homogenere Leuchtdichteverteilung erforderliche Widerstandswert an einem oder mehreren der zur Kontaktierung vorgesehenen Kontaktbereiche 12 ermittelt werden.

Sollte nun festgestellt werden, dass einer der zur Kontaktierung der ersten Elektrodenschicht 11a vorgesehenen Kontaktbereiche gegenüber dem zweiten zur Kontaktierung der ersten Elektrodenschicht 11a vorgesehenen Kontaktbereich einen erhöhten Kontakt- oder Übergangswiderstand aufweist, kann nun jeweils der Widerstandswert des Kontaktbereichs mit dem niedrigeren Widerstandswert mittels eines Widerstandsabgleichs erhöht werden, um eine homogenere Leuchtdichteverteilung der Schichtstruktur zu erhalten.

Gemäß Ausführungsbeispielen der vorliegenden Erfindung ist es alternativ möglich, auch bei beiden zur Kontaktierung der ersten Elektrodenschicht 11a vorgesehenen Kontaktbereichen 12, 13 deren Widerstandswert mittels eines Widerstandsabgleichs so einzustellen, dass an beiden Kontaktbereichen 12 ein (innerhalb eines Toleranzbereiches) gleicher Kontaktwiderstand vorliegt. Ferner ist es möglich, an beiden zur Kontaktierung der ersten Elektrodenschicht 11a vorgesehenen Kontaktbereichen 12 den Widerstandswert so zu erhöhen, dass mögliche Kontakt- und Übergangswiderstände einen geringen oder keinen negativen Einfluss mehr auf eine homogene Leuchtdichteverteilung bzw. auf eine symmetrische Einspeisung des Betriebsstroms haben. Bei diesen beiden letzteren Alternativen wird somit durch den Widerstandsabgleich beider zur Kontaktierung der ersten Elektrodenschicht 11a vorgesehenen Kontaktbereiche 12 ein Serien- oder Vorwiderstand, der seriell zur Betriebsstromeinspeisung in das OLED-Panel angeordnet ist, vorgesehen.

Um nun an einem Kontaktbereich 12 ein abgleichbares Widerstandselement 12a vorzusehen, können die jeweiligen zur Kontaktierung der ersten Elektrodenschicht 11a vorgesehenen Kontaktbereiche 12 als abgleichbare bzw. trimmbare Dickschichtwiderstandsstrukturen oder Dünnschichtwiderstandsstrukturen ausgebildet sein oder beispielsweise ein trimmbares SMD-Widerstandsbauelement oder eine trimmbare integrierte Widerstandsstruktur aufweisen, wobei der Abgleichvorgang dann mittels eines Lasertrimmvorgangs oder eines Laserablationsvorgangs durchgeführt werden kann. Alternativ kann jeder geeignete Vorgang zum gezielten Abtragen von Material des Widerstandselements zur Einstellung des Widerstandswerts eingesetzt werden.

Fig. 1b stellt eine vergrößerte Detailansicht eines Eckbereichs des OLED-Panels 10 und den Kontaktbereichen 12, 13 dar. In Fig. 1b ist nun beispielhaft ein Kontaktbereich 12 zur Kontaktierung der ersten Elektrodenschicht 11a, der beispielsweise ein abgleichbares Widerstandselement 12a aufweist, und ein nicht abgleichbarer Kontaktbereich 13 zur Kontaktierung der zweiten Elektrodenschicht 11c dargestellt. Dabei kann der Widerstandswert des Kontaktbereichs 12 zur Kontaktierung der ersten Elektrodenschicht 11a durch Lasertrimmen oder Laserablation verändert werden, so dass sich der Serienwiderstand des Kontaktbereichs 12 erhöht und sich somit ein Vorwiderstand für das OLED-Panel ausbildet.

Durch Abtragen von Widerstandsmaterial, z.B. mittels Einschnitten in die Widerstandsschicht, wird unter Verwendung eines fokussierten Laserstrahls der Querschnitt des Widerstandsmaterials verändert, d.h. verringert, oder dessen wirksame Länge wird vergrößert. Dadurch erhöht sich der elektrische Widerstand. Diese Vorgehensweise ist anwendbar, um eine Widerstandserhöhung durchzuführen. Bezüglich der Schnittform können beispielsweise gerade Schnitte von der Seite quer zur Widerstandsbahn ausgeführt werden. Bei hohen Abgleichgenauigkeiten kann man einen sogenannten L-Schnitt verwenden, der aus einem Quer-Einschnitt und einem daran anschließenden, längs zur Widerstandsbahn verlaufenden Schnitt besteht. Letzterer Längs-Schnitt verursacht eine geringere Widerstandsänderung pro Schnittlänge und erlaubt daher einen feineren Widerstandsabgleich. In Fig. 1a ist lediglich ein Quer-Einschnitt zur Verlängerung der Widerstandsbahn und damit zur Erhöhung des gewünschten Widerstandswerts dargestellt.

Gemäß einem weiteren Beispiel wie es in Fig. 2ab dargestellt ist, können auch mehrere Kontaktbereiche bei den aufgeteilten Elektroden mit einem abgleichbaren Widerstandselement zum Auskoppeln des Betriebsstroms versehen sein, an denen ein Widerstandsabgleich durchführbar ist. Aus diesem Grund kann damit sowohl für die zur Kontaktierung der ersten Elektrodenschicht 11a vorgesehenen Kontaktbereiche 12 (z.B. Anodenkontaktbereiche) als auch für die zur Kontaktierung der zweiten Elektrodenschicht 11c vorgesehenen Kontaktbereiche 13 (z.B. Kathodenkontaktbereiche) jeweils der erforderliche Widerstandswert an den zur Kontaktierung vorgesehenen Kontaktbereichen des OLED-Panels ermittelt werden, um eine möglichst homogene Leuchtdichteverteilung des OLED-Panels zu erhalten. Die Ermittlung der jeweiligen Widerstandswerte für die zur Kontaktierung vorgesehenen Kontaktbereiche des OLED-Panels kann dann entsprechend der anhand des ersten Ausführungsbeispiels dargestellten Vorgehensweise der Messung von Inhomogenitäten für jeden zur Kontaktierung vorgesehenen Kontaktbereich des OLED-Panels durchgeführt werden. Auch in diesem Fall weist jeder Kontaktbereich 12, 13, dessen Widerstandswert abgleichbar ausgebildet werden soll, ein abgleichbares Widerstandselement 12a, 13a auf.

Im Zusammenhang aller Ausführungsbeispiele der vorliegenden Erfindung ist zu beachten, dass entsprechend der Formulierung "ein Kontaktbereich weist ein abgleichbares Widerstandselement auf' beispielsweise zumindest ein Bereich des Kontaktbereichs selbst strukturierbar oder abgleichbar ist, um eine Widerstandsänderung an dem Kontaktbereich vorzunehmen. Ferner können zusätzliche abgleichbare Widerstandsstrukturen an den jeweiligen Kontaktbereichen 12, 13 angeordnet oder mit denselben elektrisch verbunden sein, um ein abgleichbares Widerstandselement an den jeweiligen Kontaktbereichen vorzusehen.

Werden nun gemäß dem vorigen Beispiel die für eine homogenere Leuchtdichteverteilung des OLED-Panels erforderlichen Widerstandswerte sowohl an den zur Kontaktierung der ersten Elektrodenschicht 11a als auch an den zur Kontaktierung der zweiten Elektrodenschicht 11c vorgesehenen Kontaktbereichen 12, 13 ermittelt, können nun, wie dies in Fig. 2b dargestellt ist, die Widerstandswerte an beiden Anschlussarten, d.h. den Anodenanschlüssen als auch den Kathodenanschlüssen, verändert werden. Fig. 2b stellt wiederum eine vergrößerte Detailansicht des Eckbereichs des OLED-Panels 10 mit dem aktiven Schichtstapel 11 und den Kontaktbereichen 12, 13 dar. Wie in Fig. 2b dargestellt ist, sind Schnitte 15 und 16 in den Anschlusskontakten vorgesehen, diese Schnitte können durch Abtragen von Widerstandsmaterial in Form von Einschnitten oder Vertiefungen in die Widerstandsschicht des jeweiligen Kontaktbereichs mit einem fokussierten Laserstrahl vorgesehen werden, so dass sich der Querschnitt des Widerstandselements verringert, wodurch sich der resultierende elektrische Widerstand gezielt erhöhen lässt.

Die in Fig. 2b dargestellten Quer-Schnitte sind wieder lediglich beispielhaft anzunehmen, wobei auch bei den in Fig. 2b ausgeführten Ausführungsbeispielen gleichermaßen anstatt der Quer-Schnitte auch Längs-Schnitte zur Erhöhung des Widerstandswerts entsprechend vorgesehen werden können. Auch hier kann jeder geeignete Vorgang zum gezielten Abtragen von Material des Widerstandselements zur Einstellung des Widerstandswerts eingesetzt werden.

Gemäß dem anhand von Fig. 2a-b dargestellten Beispiel lässt sich der Vorwiderstand des OLED-Panels verändern, um die Auswirkungen störender Kontakt- und Übergangswiderstände auf die Homogenität der Leuchtdichteverteilung über der Abstrahlfläche des flächigen Leuchtkörpers zu verringern, wobei der Widerstandsabgleich auch entsprechend der Vorgehensweise bei dem ersten Beispiel durchgeführt werden kann.

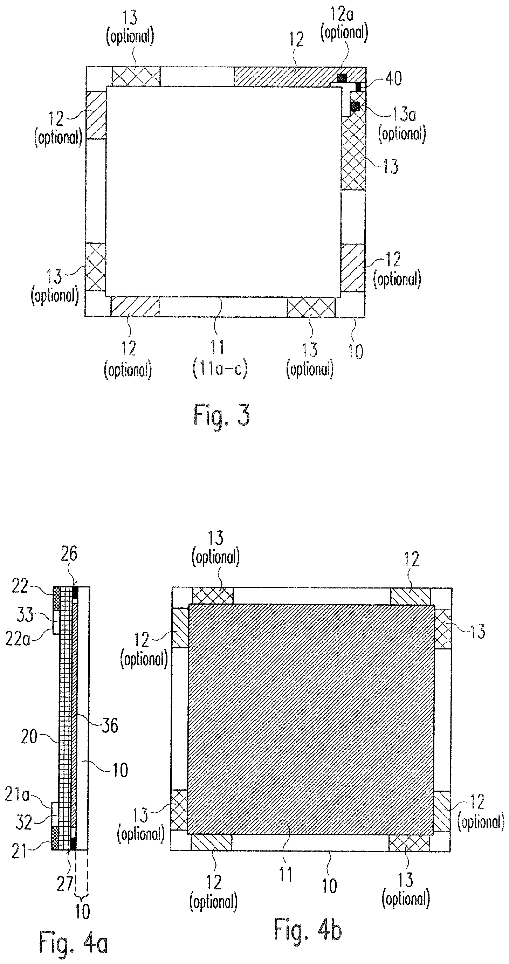

Fig. 3 zeigt nun eine schematische Draufsicht auf ein OLED-Panel 10, wobei das OLED-Panel 10 einen aktiven Schichtstapel 11 und Kontaktbereiche 12, 13 zur Kontaktierung des aktiven Schichtstapels 11 aufweist. Dabei kann beispielsweise der Kontaktbereich 12 als Anodenkontaktbereich und der Kontaktbereich 13 als Kathodenkontaktbereich (oder umgekehrt) ausgebildet sein. Die Kontaktbereiche 12, 13 können nun optional jeweils ein abgleichbares Widerstandselement 12a, 13a (entsprechend den oben dargestellten Ausführungsbeispielen) aufweisen. Wie nun in Fig. 3 dargestellt ist, ist nun zwischen dem beispielsweise zur Kontaktierung der ersten Elektrodenschicht 11a vorgesehenen Kontaktbereich 12 (z.B. Anodenkontaktbereich) und dem zur Kontaktierung der zweiten Elektrodenschicht 11c vorgesehenen Kontaktbereich 13 (z.B. Kathodenkontaktbereich) ein hinsichtlich des Innenwiderstands des OLED-Panels hochohmiges Widerstandselement 40 vorgesehen, das somit zwischen die Kontaktbereiche 12 und 13 geschaltet ist. Das Widerstandselement 40 kann nun wiederum abgleichbar ausgebildet sein. Auch bei diesem Ausführungsbeispiel kann das abgleichbare Widerstandselement 40 jeweils eine abgleichbare bzw. trimmbare Dickschichtwiderstandsstruktur, eine trimmbare Dünnschichtwiderstandsstruktur, ein trimmbares SMD-Widerstandselement oder eine trimmbare integrierte Widerstandsstruktur aufweisen, die wiederum mittels eines Lasertrimmvorgangs oder eines Laserablationsvorgangs auf den jeweils erforderlichen Widerstandswert eingestellt bzw. erhöht werden kann.

Alternativ können als das abgleichbare Widerstandselement 40 ein einstellbares Potentiometer oder eine programmierbare elektronische Lastschaltung verwendet werden, wobei dann der jeweilige Widerstandswert des Potentiometers oder der programmierbaren elektronischen Lastschaltung auf den jeweiligen erforderlichen Widerstandswert eingestellt werden kann. Alternativ kann ferner als abgleichbares Widerstandselement 40 ein festes Widerstandselement, z.B. ein SMD-Widerstandselement mit einem festen Widerstandswert, der dem jeweiligen erforderlichen Widerstandswert zum Erreichen einer homogenen Leuchtdichteverteilung entspricht, zwischen die Kontaktbereiche 12, 13 geschaltet werden, um den für eine homogenere Leuchtdichteverteilung jeweils erforderlichen Widerstandswerte durch eine Parallelschaltung der Kontaktbereiche 12, 13 des OLED-Panels 10 vorzusehen.

Gemäß dem in Fig. 3 dargestellten Beispiel wird also an den Kontaktbereichen 12, 13 ein trimmbarer Widerstand parallel zur lichtemittierenden Schicht 12 vorgesehen, das heißt es wird zwischen dem zur Kontaktierung der ersten Elektrodenschicht 11a vorgesehenen Kontaktbereich 12 und dem zur Kontaktierung der zweiten Elektrodenschicht 11c vorgesehenen Kontaktbereich 13 ein relativ hochohmiger Widerstand 40 vorgesehen. Falls mehrere Kontaktbereiche 12 zur Stromeinspeisung und mehrere Kontaktbereiche 13 zur Stromauskopplung vorgesehen sind, können auch mehrere abgleichbare Widerstandselemente 40 zwischen jeweils zugeordneten Kontaktbereichen 12, 13 angeordnet werden. Somit kann auch an mehreren Kontaktbereichen 12, 13 jeweils ein abgleichbares Widerstandselement 40 parallel zur lichtemittierenden Schicht 11, das heißt parallel zwischen den Eingangs- und Ausgangsanschluss, des OLED-Panels 10 geschaltet werden. Dieses zusätzliche, parallel geschaltete abgleichbare Widerstandselement 40 ist relativ hochohmig zu wählen, beispielsweise in einem Bereich ab 500 Ohm oder einem kilo-Ohm (d.h. beispielsweise in einem Bereich von 0,5 bis 50 kilo-Ohm), so dass nur ein relativ geringer Stromfluss über dieses parallel geschaltete abgleichbare Widerstandselement 40 fließt und somit die Verlustleistung durch dieses Widerstandselement 40 gering gehalten wird. Ferner kann der Widerstandswert des abgleichbaren Widerstandselements 40 gewählt werden, um mehr als das 10- oder 20-fache des Innenwiderstands des OLED-Panels zu betragen. Durch das Vorsehen dieses weiteren, abgleichbaren Widerstandselements 40 parallel zu dem aktiven, lichtemittierenden Schichtstapel 11 wird ein weiterer Einstellparameter bzw. Freiheitsgrad erhalten, der variiert werden kann, um möglichen Inhomogenitäten in der Leuchtdichte des OLED-Panels 10 entgegenzuwirken.

Mit dem zusätzlichen abgleichbaren Widerstandselement 40 können nicht nur Asymmetrien an den Zuleitungswiderständen ausgeglichen werden, sondern auch lokale Inhomogenitäten innerhalb der Elektrodenschichtmaterialien (Kathoden- bzw. Anodenschicht) und der organischen, lichtemittierenden Schicht(en) verringert bzw. ausgeglichen werden. Basierend auf dem parallel zu dem aktiven Schichtstapel 11 zusätzlich angeordneten, abgleichbaren Widerstandselement 40 kann beispielsweise die Diodenkennlinie des OLED-Panels in einen gewissen Rahmen eingestellt werden. Basierend auf den zusätzlichen Widerstandselement 40 zwischen den Kontaktbereichen 12, 13 kann also ein paralleles Widerstandselement zu dem als Diode wirksamen OLED-Panel 10 ausgebildet werden, während durch die an den Kontaktbereichen 12 (und optional 13) vorgesehenen abgleichbaren Widerstandselemente 12a, 13b ein Vorwiderstand bzw. serieller Widerstand zu dem als Diode wirksamen OLED-Panel 10 gebildet werden kann.

Somit kann erfindungsgemäß entweder über die gezielte Einstellung des Serienwiderstands (Vorwiderstands) oder des Parallelwiderstands oder über eine geeignete Kombination des Serien- und Parallelwiderstands eine Erhöhung der Homogenität der Leuchtdichteverteilung über der Abstrahlfläche des OLED-Panels erreicht werden.

Das in Fig. 4a dargestellte Ausführungsbeispiel zeigt in Seitenansicht ein OLED-Modul, bei dem ein OLED-Panel 10 mit einem Basiselement 20, bspw. einer Platine, verbunden ist. Das OLED-Modul weist definierte elektrische (und eventuell andere) Schnittstellen auf, so dass ein solches OLED-Modul in einfacher Art und Weise ohne eine individuelle Anpassung in eine Leuchte eingebaut werden kann. Eine Funktion eines solchen OLED-Moduls wäre dann unter anderem den Strom von definierten Schnittstellen (Außenkontakten) auf die jeweiligen, an die Form des OLED-Panels optimierte Kontaktierungsstellen/Kontaktbereiche des OLED-Panels zu verteilen. Das OLED-Modul weist also Zwischenkontaktbereiche 26, 27 an einer ersten, dem OLED-Panel 10 zugewandten Hauptoberfläche der Platine 20 auf, die mit den zur Kontaktierung des OLED-Panels vorgesehenen Kontaktbereichen an dem OLED-Panel elektrisch verbunden sind. Die Platine 20 weist ferner Außenkontakte 21, 22 an einer zweiten Hauptoberfläche auf, wobei die Außenkontakte 21, 22 der Platine 20 durch die Platine 20 hindurch mit den Zwischenkontaktbereichen 26, 27 auf der ersten Hauptoberfläche elektrisch verbunden sind. Die Außenkontakte 21, 22 sind vorgesehen, um z.B. mit einer Trägerplatte (nicht gezeigt), beispielsweise einer Leuchte (oder einer Fassung) und den dortigen Kontakten elektrisch verbunden zu werden.

Bezüglich der Platine 20 wird darauf hingewiesen, dass diese beispielsweise zwei (oder auch einer größere Anzahl) von Außenkontakten an vordefinierten, standardisierten Kontaktierungsstellen aufweisen kann, die dann ausgehend von der zweiten Hauptoberfläche der Platine 20 zu beispielsweise vier oder mehr Zwischenkontaktbereichen auf der ersten Hauptoberfläche der Platine 20 geführt sein können. Damit kann der Betriebsstrom für den flächigen Leuchtkörper von beispielsweise zwei Außenkontakten innerhalb der Platine 20 auf eine größere Anzahl von Zwischenkontakten auf die erste Hauptoberfläche der Platine 20 geführt werden, um die OLED-Kontaktbereiche, d.h. die Kontaktbereiche 12, 13 des OLED-Panels 10, zu kontaktieren. Diese Kontaktierung zwischen den Zwischenkontaktbereichen auf der Platine 20 zu den Kontaktbereichen 12, 13 auf dem OLED-Panel ist in der Fig. 4a schematisch durch die elektrisch leitfähigen Verbindungselemente 32, 33 angedeutet.

In der Fig. 4a ist ein OLED-Panel 10 mit einer Platine 20 verbunden ist, um das OLED-Modul zu bilden. Erfindungsgemäß ist es aber gleichermaßen möglich, eine Mehrzahl von OLED-Panels 10 jeweils auf der Platine 20 anzuordnen, um ein OLED-Modul mit einer Mehrzahl von OLED-Panels 10 zu bilden, das wiederum an der Trägerplatte befestigbar bzw. in eine Fassung einsetzbar ist. Das OLED-Panel 10 kann mittels beliebiger mechanischer Befestigungselemente (bspw. mittels Klebstoff oder Lotmaterial) an der Platine 20 befestigt sein. In Fig. 4a ist das OLED-Panel mittels einer Klebstoffschicht 36 mechanisch mit der Platine 20 verbunden.

Nach der Ermittlung des für eine homogenere Leuchtdichteverteilung des OLED-Panels 10 erforderlichen Widerstandswerts bzw. der Widerstandswerte basierend auf der erfassten Position, Ausdehnung und/oder Leuchtdichte einer oder mehrere Inhomogenitäten in der Leuchtdichteverteilung kann nun beispielsweise ein Abgleich auf den für eine homogenere Leuchtdichteverteilung erforderlichen Widerstandswert bzw. die Widerstandswerte an den Kontaktbereichen der Platine 20 an dort vorgesehenen abgleichbaren Widerstandselementen 21a, 22a vorgenommen werden. So ist beispielsweise ein abgleichbares Widerstandselement 21a, 22a seriell zwischen den Zwischenkontakt 26, 27 auf der ersten Hauptoberfläche der Platine 20, der mit dem zumindest einen Kontaktbereich 12 des OLED-Panels 10 verbunden ist, und den zugeordneten Außenkontakt 21, 22 geschaltet. Erfindungsgemäß kann somit beispielsweise zwischen jeden Außenkontakt 21, 22 der Platine 20 und jeden zugeordneten Zwischenkontakt 26, 27 der Platine 20 ein abgleichbares Widerstandselement 21a, 22a geschaltet werden, das entsprechend des jeweiligen ermittelten Widerstandswerts für den zugeordneten Kontaktbereich an dem OLED-Panel 10 auf den erforderlichen Widerstandswert abgeglichen werden kann. Erfindungsgemäß weist das an der Platine 20 angeordnete abgleichbare Widerstandselement 21a, 22a jeweils eine abgleichbare bzw. trimmbare Dickschichtwiderstandsstruktur, eine trimmbare Dünnschichtwiderstandsstruktur, ein trimmbares SMD-Widerstandselement oder eine trimmbare integrierte Widerstandsstruktur auf, die wiederum mittels eines Lasertrimmvorgangs oder eines Laserablationsvorgangs auf den jeweils erforderlichen Widerstandswert eingestellt bzw. erhöht werden können.

Alternativ können als jeweiliges abgleichbares Widerstandselement 21a, 22a ein einstellbares Potentiometer oder eine programmierbare elektronische Lastschaltung verwendet werden, wobei dann der jeweilige Widerstandswert des Potentiometers oder der programmierbaren elektronischen Lastschaltung auf den jeweiligen erforderlichen Widerstandswert eingestellt werden kann.

Bezüglich der im Vorhergehenden dargestellten Einstellung des für eine homogene Leuchtdichteverteilung erforderlichen Widerstandswerts an einem oder mehreren Kontaktbereichen 12, 13 des OLED-Panels 10 oder zwischen einem zur Stromeinprägung vorgesehenen Kontaktbereich 12 und einem zur Stromauskopplung vorgesehen Kontaktbereich 13 des OLED-Panels 10 zur Erhöhung der Homogenität der Leuchtdichte eines flächigen Leuchtkörpers wird ferner darauf hingewiesen, dass der jeweilige Widerstandsabgleich, d.h. die Einstellung auf den erforderlichen Widerstandswert, vor oder auch nach der Verkapselung des OLED-Panels erfolgen kann, da die erforderliche Einstellung der Widerstandswerte an nach außen zugänglichen Bereichen des OLED-Panels oder OLED-Moduls vorgenommen werden kann.

Bezüglich der im vorhergehenden dargestellten Ausführungsbeispiel wird darauf hingewiesen, dass die als abgleichbare Widerstandselemente ausgebildeten trimmbaren Dickschichtwiderstandsstrukturen oder trimmbaren Dünnschichtwiderstandsstrukturen auch als Leiterbahnen auf der OLED-Panel 10 oder der Platine 20 angeordnet sein können.

Im Zusammenhang der vorliegenden Erfindung wird ferner darauf hingewiesen, dass bei der Ermittlung des jeweiligen für eine homogenere Leuchtdichteverteilung des OLED-Panels erforderlichen Widerstandswerts an zumindest einem der Mehrzahl zur Kontaktierung vorgesehenen Kontaktbereiche des OLED-Panels dieser Widerstandswert innerhalb eines Toleranzbereiches bezüglich des exakten für eine absolut homogene Leuchtdichteverteilung der Kontaktbereiche bestimmt wird, wobei der Widerstandswert beispielsweise mit einer Mindestgenauigkeit von mehr als 50%, 80% oder 95% bezüglich des exakten Widerstandswerts (für eine absolut homogene Leuchtdichteverteilung) ermittelt wird.

Gleichermaßen ist zu beachten, dass bei dem Einstellen des jeweiligen Widerstandswerts an dem zumindest einem der Mehrzahl zur Kontaktierung vorgesehenen Kontaktbereiche auf dem für eine homogene Leuchtdichteverteilung des OLED-Panels erforderlichen Widerstandswert diese Widerstandswerteinstellung wiederum innerhalb eines Toleranzbereiches mit einer Genauigkeit von mehr als 50%, 80% oder 95% auf den jeweiligen ermittelten Widerstandswert erfolgen kann. Die Toleranzbereiche bei der Einstellung des Widerstandswertes können sich beispielsweise aus den Toleranzen bei dem Abgleich der Widerstandswerte mittels eines Lasertrimmvorgangs oder eines Laserablationsvorgangs ergeben.

Bei dem erfindungsgemäßen Verfahren zum Erhöhen der Homogenität der Leuchtdichteverteilung über der Abstrahlfläche eines flächigen Leuchtkörpers, der ein OLED-Panel mit einer Mehrzahl von Kontaktbereichen 12 zur Einspeisung eines Betriebsstroms und mit zumindest einem Kontaktbereich 13 zum Auskoppeln des Betriebsstroms aufweist, wird also zunächst ein für eine homogene Leuchtdichteverteilung des OLED-Panels 10 erforderlicher Widerstandswert an zumindest einem der Mehrzahl zur Kontaktierung vorgesehenen Kontaktbereiche 12, 13 ermittelt. Daraufhin wird der Widerstandswert an dem zumindest einen der Mehrzahl zur Kontaktierung vorgesehenen Kontaktbereiche 12, 13 auf den für eine homogenere Leuchtdichteverteilung des OLED-Panels 10 erforderlichen Widerstandswert eingestellt.

Die anhand der Fig. 1a-b, 2a-b, 3 und 4b im vorhergehenden beschriebenen Beispiele und das Ausführungsbeispiel in Fig. 4b zeigen jeweils eine Draufsicht auf eine OLED-Panel mit den Kontaktbereichen 12, 13. Bezüglich der Kontaktbereich 12, 13 sollte beachte werden, dass sich diese zur Kontaktierung der verschiedenen Elektrodenschichten 11a, 11c der Schichtstapels 11 in unterschiedlichen Ebenen zueinander befinden können, wobei die Kontaktbereiche 12, 13 beispielsweise mittels isolierender Abstandsstrukturen räumlich und elektrisch voneinander getrennt sind.

## Patentansprüche

1. Flächiger Leuchtkörper mit folgenden Merkmalen:
einer Schichtanordnung (10) mit einer ersten Elektrodenschicht (11a), einer zweiten Elektrodenschicht (11c) und zumindest einer dazwischen liegenden lichtemittierenden Schicht (11b), wobei eine Mehrzahl von Kontaktbereichen (12) zur Kontaktierung der ersten Elektrodenschicht (11a) und zumindest ein Kontaktbereich (13) zur Kontaktierung der zweiten Elektrodenschicht (11c) vorgesehen sind,
wobei zumindest ein Kontaktbereich (12, 13) der zur Kontaktierung vorgesehenen Kontaktbereiche (12, 13) ein abgleichbares Widerstandselement (12a, 13a; 21a, 22a) aufweist, oder wobei ein abgleichbares Widerstandselement (40) zwischen einen zur Kontaktierung der ersten Elektrodenschicht vorgesehenen Kontaktbereich (12) und einen zur Kontaktierung der zweiten Elektrodenschicht vorgesehenen Kontaktbereich (13) geschaltet ist,
wobei der Widerstandswert des abgleichbaren Widerstandselements (12a, 13a; 21a, 22a; 40) auf einen geänderten Widerstandswert einstellbar ist,
**dadurch gekennzeichnet,**
**dass** die Schichtanordnung (10) mit einem Basiselement (20), insbesondere einer Platine, verbunden ist, und das Basiselement (20) Zwischenkontaktbereiche (26, 27) an einer der ersten, der Schichtanordnung (10) zugewandten Hauptoberfläche, die mit den Kontaktbereichen (12, 13) der Schichtanordnung (10) verbunden sind, und Außenkontakte (21, 22) an einer zweiten Hauptoberfläche, die mit den zugehörigen Zwischenkontaktbereichen (26, 27) auf der ersten Hauptoberfläche des Basiselements (20) elektrisch verbunden sind, aufweist,
wobei das abgleichbare Widerstandselement (21a, 22a) seriell zwischen den Zwischenkontaktbereich (26, 27) auf der ersten Hauptoberfläche des Basiselements (20), der mit dem zumindest einen zur Kontaktierung vorgesehenen Kontaktbereich (12, 13) der Schichtanordnung (10) elektrisch verbunden ist, und den zugeordneten Außenkontakt (21, 22) geschaltet ist,
wobei das abgleichbare Widerstandselement eine trimmbare Dickschichtwiderstandsstruktur, eine trimmbare Dünnschichtwiderstandsstruktur, ein trimmbares SMD-Widerstandselement oder eine trimmbare integrierte Widerstandsstruktur aufweist oder
wobei das abgleichbare Widerstandselement ein einstellbares Potentiometer oder eine programmierbare elektronische Lastschaltung aufweist.

2. Flächiger Leuchtkörper nach Anspruch 1, wobei der Widerstandswert des abgleichbaren Widerstandselements (12a, 13a; 21a, 22a; 40) mittels eines Lasertrimmvorgangs oder eines Laserablationsvorgangs einstellbar ist.

3. Flächiger Leuchtkörper nach einem der vorhergehenden Ansprüche, wobei die Schichtanordnung (10) eine Mehrzahl von Kontaktbereichen (13) zur Kontaktierung der zweiten Elektrodenschicht (11c) aufweist,
und/oder
jeder der zur Kontaktierung vorgesehenen Kontaktbereiche (12, 13) ein abgleichbares Widerstandselement aufweist.

4. Flächiger Leuchtkörper nach einem der vorhergehenden Ansprüche, wobei die erste Elektrodenschicht (11a) als eine Anodenschicht der Schichtanordnung (10) und die zweite Elektrodenschicht (11c) als eine Kathodenschicht der Schichtanordnung (10) ausgebildet ist
oder
die erste Elektrodenschicht (11a) als eine Kathodenschicht der Schichtanordnung (10) und die zweite Elektrodenschicht (11c) als eine Anodenschicht der Schichtanordnung (10) ausgebildet ist.

5. Verfahren zum Erhöhen der Homogenität der Leuchtdichte eines flächigen Leuchtkörpers, wobei der flächige Leuchtkörper eine Schichtanordnung (10) mit einer ersten Elektrodenschicht, einer zweiten Elektrodenschicht und zumindest einer dazwischen liegenden lichtemittierenden Schicht und eine Mehrzahl von Kontaktbereichen zur Kontaktierung der ersten Elektrodenschicht und zumindest einen Kontaktbereich zur Kontaktierung der zweiten Elektrodenschicht aufweist, mit folgenden Schritten:
Ermitteln eines für eine homogenere Leuchtdichteverteilung der Schichtanordnung erforderlichen Widerstandswert an zumindest einem der Mehrzahl zur Kontaktierung der Kontaktbereiche (12, 13) der Schichtanordnung (10), bei dem sich gegenüber einem unveränderten Widerstandswert eine homogenere Leuchtdichteverteilung der Schichtanordnung (10) ergibt; und
Einstellen des Widerstandswerts an den zumindest einem der Mehrzahl zur Kontaktierung vorgesehenen Kontaktbereiche (12, 13) auf den für eine homogenere Leuchtdichteverteilung der Schichtanordnung (10) erforderlichen Widerstandswert
**dadurch gekennzeichnet,**
**dass** die Schichtanordnung (10) mit einem Basiselement 20, insbesondere einer Platine, verbunden ist, und das Basiselement (20) Zwischenkontaktbereiche an einer der ersten, der Schichtanordnung (10) zugewandten Hauptoberfläche, die mit den Kontaktbereichen (12, 13) der Schichtanordnung (10) elektrisch verbunden sind, und Außenkontakte (21, 22) an einer zweiten Hauptoberfläche, die mit den zugehörigen Zwischenkontaktbereichen auf der ersten Hauptoberfläche des Basiselements (20) elektrisch verbunden sind, aufweist,
wobei bei dem Schritt des Einstellens des Widerstandswerts ein Widerstandsabgleich an einem abgleichbaren Widerstandselement (21a, 22a) durchgeführt wird, das seriell zwischen den Zwischenkontaktbereich auf der ersten Hauptoberfläche des Basiselements (20), der mit dem zumindest einen Kontaktbereich (12, 13) der Schichtanordnung (10) verbunden ist, und den zugeordneten Außenkontakt (21, 22) geschaltet ist,
wobei das abgleichbare Widerstandselement eine trimmbare Dickschichtwiderstandsstruktur, eine trimmbare Dünnschichtwiderstandsstruktur, ein trimmbares SMD-Widerstandselement oder eine trimmbare integrierte Widerstandsstruktur aufweist oder wobei das abgleichbare Widerstandselement ein einstellbares Potentiometer oder eine programmierbare elektronische Lastschaltung aufweist.

6. Verfahren nach Anspruch 5, wobei der Schritt des Ermittelns folgenden Teilschritt aufweist:
Auswerten der von der Schichtanordnung (10) erreichten Homogenität der Leuchtdichteverteilung bei einer Betriebsstromeinspeisung, wobei der für eine homogenere Leuchtdichteverteilung erforderliche Widerstandswert basierend auf der Leuchtdichteverteilung ermittelbar ist,
und wobei vorzugsweise der Schritt des Auswertens folgende Teilschritte aufweist:
Erfassen einer Position, Ausdehnung und/oder Leuchtdichte einer Inhomogenität in der Leuchtdichteverteilung, und
Ermitteln des für eine homogenere Leuchtdichteverteilung erforderlichen Widerstandswerts basierend auf der erfassten Position, Ausdehnung und/oder Leuchtdichte.

7. Verfahren nach Anspruch 5 oder 6, wobei der zumindest eine Kontaktbereich (12, 13) ein abgleichbares Widerstandselement (12a, 13a) aufweist, wobei der Schritt des Einstellens des Widerstandswerts mittels eines Widerstandsabgleichs an dem abgleichbaren Widerstandselements (12a, 13a) durchgeführt wird.

8. Verfahren nach einem der Ansprüche 5 bis 7, wobei zwischen einen der zur Kontaktierung der ersten Elektrodenschicht vorgesehenen Kontaktbereiche (12) und einen zur Kontaktierung der zweiten Elektrodenschicht vorgesehenen Kontaktbereich (13) ein abgleichbares Widerstandselement (40) geschaltet ist, wobei der Schritt des Einstellens des Widerstandswerts mittels eines Widerstandsabgleichs an dem abgleichbaren Widerstandselement (40) durchgeführt wird.

9. Verfahren nach Anspruch 7 oder 8, wobei der Widerstandsabgleich mittels eines Lasertrimmvorgangs oder eines Laserablationsvorgangs durchgeführt wird.

10. Verfahren nach einem der Ansprüche 7 bis 9, wobei das abgleichbare Widerstandselement eine trimmbare Dickschichtwiderstandsstruktur, eine trimmbare Dünnschichtwiderstandsstruktur, ein trimmbares SMD-Widerstandselement oder eine trimmbare integrierte Widerstandsstruktur aufweist, wobei der Schritt des Einstellens des Widerstandswerts mittels eines Lasertrimmvorgangs oder eines Laserablationsvorgangs durchgeführt wird.

11. Verfahren nach einem der Ansprüche 7 bis 10, wobei das abgleichbare Widerstandselement ein einstellbares Potentiometer oder eine programmierbare elektronische Lastschaltung aufweist, wobei bei dem Schritt des Einstellens des Widerstandswerts der Widerstandswert des Potentiometers oder der programmierbaren elektronischen Lastschaltung eingestellt wird.

12. Verfahren nach einem der Ansprüche 5 bis 11, wobei die Schichtanordnung (10) ferner eine Mehrzahl von Kontaktbereichen (13) zur Kontaktierung der zweiten Elektrodenschicht aufweist.

13. Verfahren nach einem der Ansprüche 5 bis 12, wobei jeder der zu Kontaktierung vorgesehenen Kontaktbereiche (12, 13) ein abgleichbares Widerstandselement (12a, 13a) aufweist, wobei die Schritte des Ermittelns und des Einstellens eines Widerstandswerts für jeden der Mehrzahl zur Kontaktierung vorgesehenen Kontaktbereiche (12, 13) durchgeführt wird.

## Claims

1. A planar luminous element with the following features:
A layer assembly (10) with a first electrode layer (11a), a second electrode layer (11c) and at least one light-emitting layer (11b) interposed between said layers, wherein a plurality of contact regions (12) for contacting the first electrode layer (11a) and at least one contact region (13) for contacting the second electrode layer (11c) are provided,
wherein at least one contact region (12, 13) of the contact regions (12, 13) provided for contacting has a trimmable resistance element (12a, 13a; 21a, 22a) or wherein a trimmable resistance element (40) is connected between a contact region (12) provided for contacting the first electrode layer and a contact region (13) provided for contacting the second electrode layers,
wherein the resistance value of the trimmable resistance element (12a, 13a; 21a, 22a; 40) can be set to a modified resistance value,
**characterized in**
**that** the layer assembly (10) is connected with a base element (20), in particular with a circuit board, and the base element (20) has intermediate contact regions (26, 27) on one of the first main surface facing the layer assembly (10), which are connected with the contact regions (12, 13) of the layer assembly (10), and external contacts (21, 22) on a second main surface, which are electrically connected to the associated intermediate contact regions (26, 27) on the first main surface of the base element (20),
wherein the trimmable resistance element (21a, 22a) is connected in series between the intermediate contact regions (26, 27) on the first main surface of the base element (20), which is electrically connected with the at least one contact region (12, 13) of the layer assembly (10) provided for contacting, and the assigned external contact (21, 22) wherein the trimmable resistance element has a trimmable thick layer resistance structure, a trimmable thin layer resistance structure, a trimmable SMD resistance element or a trimmable integrated resistance structure or wherein the trimmable resistance element has an adjustable potentiometer or a programmable electronic load circuit.

2. A planar luminous element according to Claim 1, wherein the resistance value of the trimmable resistance element (12a, 13a; 21a, 22a; 40) can be set by means of a laser trimming process or a laser ablation process.

3. A planar luminous element according to any one of the preceding claims, wherein the layer assembly (10) has a plurality of contact regions (13) for contacting the second electrode layer (11c),
and/or
each of the contact regions (12, 13) provided for the contacting has a trimmable resistance element.

4. A planar luminous element according to any one of the preceding claims, wherein the first electrode layer (11a) is designed as an anode layer of the layer assembly (10) and the second electrode layer (11c) as a cathode layer of the layer assembly (10)
or
the first electrode layer (11a) is designed as a cathode layer of the layer assembly (10) and the second electrode layer (11c) as an anode layer of the layer assembly (10).

5. A method for increasing the homogeneity of the luminance of a planar luminous element, wherein the planar luminous element has a layer assembly (10) with a first electrode layer, a second electrode layer and at least one light-emitting layer interposed between said layers and a plurality of contact regions for contacting the first electrode layer and at least one contact region for contacting the second electrode layer, with the following steps:
Determination of a resistance value required for a homogeneous luminance distribution on at least one of the plurality contact regions (12, 13) of the layer assembly (10) for contacting, in which a more homogeneous luminance distribution of the layer assembly (10) results compared to an unchanged resistance value; and
Setting the resistance value on the at least one of the plurality of contact regions (12, 13) provided for contacting at the resistance value required for a more homogeneous luminance distribution of the layer assembly (10)
**characterized in**
**that** the layer assembly (10) is connected with a base element (20), in particular a circuit board, and the base element (20) has intermediate contact regions on one of the first main surface facing the layer arrangement (10), which are electrically connected with the contact regions (12, 13) of the layer assembly (10), and external contacts (21, 22) on a second main surface, which are electrically connected with the associated intermediate contact regions on the first main surface of the base element (20),
wherein in the step of setting the resistance value a resistance trimming is carried out on a trimmable resistance element (21a, 22a), which is connected in series between the intermediate contact region on the first main surface of the bas element (20), which is connected with the at least one contact region (12, 13) of the layer assembly (10), and the assigned external contact (21, 22),
wherein the trimmable resistance element has a trimmable thick layer resistance structure, a trimmable thin layer resistance structure, a trimmable SMD resistance element or a trimmable integrated resistance structure or wherein the trimmable resistance element has an adjustable potentiometer or a programmable electronic load circuit.

6. A method according to Claim 5, wherein the step of the determination has the following partial step:
Evaluation of the homogeneity of the luminance distribution achieved by the layer assembly (10) during an operating power feeding, wherein the resistance value required for a more homogeneous luminance distribution can be determined based on the luminance distribution,
and wherein preferably the step of the evaluation has the following partial steps:
Detection of a position, extension and/or luminance of an inhomogeneity in the luminance distribution, and
determination of the resistance value required for a more homogeneous luminance distribution based on the detected position, extension and/or luminance.

7. A method according to Claim 5 or 6, wherein the at least one contact region (12, 13) has a trimmable resistance element (12a, 13a), wherein the step of setting the resistance value is carried out by means of a resistance trimming on the trimmable resistance element (12a, 13a).

8. A method according to an one of Claims 5 to 7, wherein between one of the contact regions (12) provided for contacting the first electrode layer and a contact region (13) for contacting the second electrode layer a trimmable reistance element (40) is connected, wherein the step of setting the resistance value is carried out by means of a resistance trimming on the trimmable resistance element (40).

9. A method according to Claim 7 or 8, wherein the resistance trimming is carried out by means of a laser trimming process or of a laser ablation process.

10. A method according to any one of Claims 7 to 9, wherein the trimmable resistance element has a trimmable thick layer resistance structure, a trimmable thin layer resistance structure, a trimmable SMD resistance element or a trimmable integrated resistance structure, wherein the step of setting the resistance value is carried out by means of a laser trimming process or of a laser ablation process.

11. A method according to any one of Claims 7 to 10, wherein the trimmable resistance element has an adjustable potentiometer or a programmable electronic load circuit, wherein in the step of setting the resistance value the resistance value of the potentiometer or of the programmable electronic load circuit is set.

12. A method according to any one of Claims 5 to 11, wherein the layer assembly (10) also has a plurality of contact regions (13) for contacting the second electrode layer.

13. A method according to any one of Claims 5 to 12, wherein each of the contact regions (12, 13) provided for contacting has a trimmable resistance element (12a, 13a), wherein the step of determining and setting a resistance value is carried out for each of the plurality of contact regions (12, 13) provided for the contacting.

## Revendications

1. Luminaire plat avec les caractéristiques suivantes :
une disposition en couches (10) avec une première couche d'électrodes (11a), une deuxième couche d'électrodes (11c) et au moins une couche émettrice de lumière (11b) disposée entre les deux, une pluralité de zones de contact (12) pour la jonction de la première couche d'électrodes (11a) et au moins une zone de contact (13) pour la jonction de la deuxième couche d'électrodes (11c) étant prévues,
au moins une zone de contact (12, 13) des zones de contact (12, 13) prévus pour la jonction comprenant un élément de résistance réglable (12a, 13a ; 21a, 22a) ou un élément de résistance réglable (40) étant branché entre une zone de contact (12) prévue pour la jonction de la première couche d'électrodes et une zone de contact (13) prévue pour la jonction de la deuxième couche d'électrodes,
la valeur de la résistance de l'élément de résistance réglable (12a, 13a ; 21a, 22a ; 40) pouvant être réglé à une valeur de résistance modifiée,
**caractérisé en ce que**
la disposition en couches (10) est reliée avec un élément de base (20), plus particulièrement une platine, et l'élément de base (20) comprend des zones de contact intermédiaires (26, 27) sur une première surface principale, orientée vers la disposition en couches (10), qui sont reliés avec les zones de contact (12, 13) de la disposition en couches (10), et des contacts externes (21, 22) sur une deuxième surface principale, qui sont reliés électriquement avec les zones de contact intermédiaires (26, 27) correspondants sur la première surface principale de l'élément de base (20),
l'élément de résistance réglable (21a, 22a) étant branché en série entre la zone de contact intermédiaire (26, 27) sur la première surface principale de l'élément de base (20), qui est reliée électriquement avec l'au moins une zone de contact (12, 13), prévue pour la jonction, de la disposition en couche (10), et le contact externe (21, 22) correspondant,
l'élément de résistance réglable présentant une structure de résistance en couche épaisse ajustable, une structure de résistance en couche mince ajustable, un élément de résistance SMD ajustable ou une structure de résistance intégrée ajustable ou
l'élément de résistance réglable comprenant un potentiomètre réglable ou un circuit de charge électronique programmable.

2. Luminaire plat selon la revendication 1, la valeur de résistance de l'élément de résistance réglable (12a, 13a ; 21a, 22a ; 40) pouvant être réglée au moyen d'un processus d'ajustement au laser ou d'un processus d'ablation au laser.

3. Luminaire plat selon l'une des revendications précédentes, la disposition en couches (10) comprenant une pluralité de zones de contact (13) pour la jonction de la deuxième couche d'électrodes (11c),
et/ou
chacune des zones de contact (12, 13) prévue pour la jonction comprend un élément de résistance réglable.

4. Luminaire plat selon l'une des revendications précédentes, la première couche d'électrodes (11a) étant conçue comme une couche d'anode de la disposition en couches (10) et la deuxième couche d'électrodes (11c) étant conçue comme une couche de cathode de la disposition en couches (10)
ou
la première couche d'électrodes (11a) étant conçue comme une couche de cathode de la disposition en couches (10) et la deuxième couche d'électrodes (11c) étant conçue comme une couche d'anode de la disposition en couches (10).

5. Procédé pour l'augmentation de l'homogénéité de la densité lumineuse d'un luminaire plat, le luminaire plat comprenant une disposition en couches (10) avec une première couche d'électrodes, une deuxième couche d'électrodes et au moins une couche émettrice de lumière disposée entre elles et une pluralité de zones de contact pour la jonction de la première couche d'électrodes et au moins une zone de contact pour la jonction de la deuxième couche d'électrodes, avec les étapes suivantes :
détermination d'une valeur de résistance nécessaire pour une répartition homogène de la densité lumineuse de la disposition en couches sur au moins une de la pluralité des zones de contact (12, 13), prévus pour la jonction, de la disposition en couches (10), dans laquelle il résulte une répartition plus homogène de la densité lumineuse de la disposition en couches (10) par rapport à une valeur de résistance inchangée ; et
réglage de la valeur de la résistance sur l'au moins une de la pluralité de zones de contact (12, 13), prévus pour la jonction, à la valeur de résistance nécessaire pour une répartition plus homogène de la densité lumineuse de la disposition en couches (10)
**caractérisé en ce que**
la disposition en couches (10) est reliée avec un élément de base (20), plus particulièrement une platine, et l'élément de base (20) comprend des zones de contact intermédiaires sur une première surface principale orientée vers la disposition en couches (10), qui sont reliées électriquement avec les zones de contact (12, 13) de la disposition en couches (10) et des contacts externes (21, 22) sur une deuxième surface principale, qui sont reliés électriquement avec les zones de contact intermédiaires correspondantes sur la première surface principale de l'élément de base (20),
moyennant quoi, lors de l'étape de réglage de la valeur de la résistance, un réglage de la résistance est effectué sur un élément de résistance réglable (21a, 22a), qui est branché en série entre la zone de contact intermédiaire sur la première surface principale de l'élément de base (20), qui est relié avec l'au moins une zone de contact (12, 13) de la disposition en couches (10) et le contact externe (21, 22) correspondant,
l'élément de résistance réglable présentant une structure de résistance en couche épaisse ajustable, une structure de résistance en couche mince ajustable, un élément de résistance SMD ajustable ou une structure de résistance intégrée ajustable ou l'élément de résistance réglable comprenant un potentiomètre réglable ou un circuit de charge électronique programmable.

6. Procédé selon la revendication 5, l'étape de détermination comprenant les étapes partielles suivantes :
analyse de l'homogénéité de la répartition de la densité lumineuse atteinte par la disposition en couches (10) lors d'une alimentation par un courant de service, la valeur de résistance nécessaire pour une répartition plus homogène de la densité lumineuse pouvant être déterminée sur la base de la répartition de la densité lumineuse,
et de préférence l'étape de l'analyse comprenant les étapes partielles suivantes :
mesure d'une position, extension et/ou densité lumineuse d'une inhomogénéité dans la répartition de la densité lumineuse et
détermination de la valeur de résistance nécessaire pour une répartition plus homogène de la densité lumineuse sur la base de la position, extension et/ou densité lumineuse mesurée.

7. Procédé selon la revendication 5 ou 6, l'au moins une zone de contact (12, 13) comprenant un élément de résistance réglable (12a, 13a), l'étape de réglage de la valeur de résistance étant effectuée au moyen d'un réglage de résistance sur l'élément de résistance réglable (12a, 13a).

8. Procédé selon l'une des revendications 5 à 7, moyennant quoi, entre une des zones de contact (12) prévus pour la jonction de la première couche d'électrodes et une zone de contact (13) prévue pour la jonction de la deuxième couche d'électrodes, est branché un élément de résistance réglable (40), l'étape de réglage de la valeur de résistance étant effectuée au moyen d'un réglage de résistance sur l'élément de résistance réglable (40).

9. Procédé selon la revendication 7 ou 8, le réglage de la résistance étant effectué au moyen d'un processus d'ajustement au laser ou d'un processus d'ablation au laser.

10. Procédé selon l'une des revendications 7 à 9, l'élément de résistance réglable présentant une structure de résistance en couche épaisse ajustable, une structure de résistance en couche mince ajustable, un élément de résistance SMD ajustable ou une structure de résistance intégrée ajustable, l'étape de réglage de la valeur de la résistance étant effectuée au moyen d'un processus d'ajustement au laser ou d'un processus d'ablation au laser.

11. Procédé selon l'une des revendications 7 à 10, l'élément de résistance réglable comprenant un potentiomètre réglable ou un circuit de charge électronique programmable, moyennant quoi, lors de l'étape de réglage de la valeur de résistance, la valeur de résistance du potentiomètre ou du circuit de charge électronique programmable est réglée.

12. Procédé selon l'une des revendications 5 à 11, la disposition en couches (10) comprenant en outre une pluralité de zones de contact (13) pour la jonction de la deuxième couche d'électrodes.

13. Procédé selon l'une des revendications 5 à 12, chacune des zones de contact (12, 13), prévue pour la jonction, comprenant un élément de résistance réglable (12a, 13a), les étapes de détermination et de réglage d'une valeur de résistance étant effectuées pour chacune de la pluralité de zones de contact (12, 13) prévus pour la jonction.
